# EUROPÄISCHE PATENTSCHRIFT

(11) **EP 1 352 471 B1**
(45) Veröffentlichungstag und Bekanntmachung des Hinweises auf die Patenterteilung: **01.06.2005**
(21) Anmeldenummer: 02711758.9
(22) Anmeldetag: 03.01.2002
(51) Int. Cl.: H03K 17/567, H01L 27/085

(54) **ELEKTRONISCHE SCHALTEINRICHTUNG UND BETRIEBSVERFAHREN**
ELECTRONIC SWITCHING DEVICE AND AN OPERATING METHOD THEREFOR
CIRCUIT ELECTRONIQUE ET PROCEDE D'UTILISATION

(30) Priorität: 16.01.2001 DE 10101744
(43) Veröffentlichungstag der Anmeldung: 15.10.2003
(73) Patentinhaber: SIEMENS AKTIENGESELLSCHAFT, 80333 München (DE)
(72) Erfinder: MITLEHNER, Heinz, 91080 Uttenreuth (DE); FRIEDRICHS, Peter, 90475 Nürnberg (DE); SCHÖRNER, Reinhold, 91091 Grossenseebach (DE)
(86) Internationale Anmeldenummer: PCT/DE2002/000004
(87) Internationale Veröffentlichungsnummer: WO 2002/056472

(56) Entgegenhaltungen:
- EP-A- 0 654 827
- WO-A-95/07571
- WO-A-95/24055
- DE-A- 19 943 785
- US-A- 6 157 049

## Beschreibung

Die Erfindung betrifft eine Schalteinrichtung und ein Verfahren zum Betreiben einer Schalteinrichtung.

Zum Versorgen eines elektrischen Verbrauchers (Gerätes, Last), insbesondere eines elektrischen Antriebs oder Motors, mit elektrischer Energie oder Leistung wird der Verbraucher in der Regel über ein Schaltgerät (eine Schalteinrichtung) zum Ein- und Ausschalten des elektrischen Stromes mit einem Leitungsabzweig eines elektrisches Versorgungsnetzes verbunden.

Zum Schalten elektrischer Ströme sind neben den überwiegend eingesetzten mechanischen Schaltgeräten mit Schaltkontakten auch elektronische Schaltgeräte bekannt, die mit Halbleiterbauelementen realisiert werden. Solche Halbleiterbauelemente kann man unterteilen in stromgesteuerte Halbleiterbauelemente, zu denen bipolare Transistoren und Thyristoren gehören, einerseits und spannungsgesteuerte Halbleiterbauelemente wie beispielsweise die unipolaren MOS(Metal-Oxide-Semiconductor)-Feldeffekttransistoren (MOSFET) oder die bipolaren MOS-gesteuerten Thyristoren (MCT) oder die MOS-gesteuerten bipolaren Transistoren (IGBT) andererseits. Alle genannten Halbleiterbauelemente können nur Ströme in einer Stromrichtung (Durchlassrichtung), d. h. nur bei einer bestimmten Polarität der anliegenden Betriebsspannung zwischen einem Durchlasszustand und einem Sperrzustand geschaltet werden (schaltbarer Zustand). Jedes Halbleiterbauelement kann in seinem Sperrzustand nur bis zu einer'maximalen Sperrspannung (Durchbruchsspannung) sperren. Bei höheren Sperrspannungen geschieht ein Ladungsträgerdurchbruch, der schnell zur Zerstörung des Bauelements führen kann.

Im normalen Dauerbetrieb (Nennbetrieb) des Verbrauchers schaltet das Schaltgerät die für den elektrischen Verbraucher erforderlichen Nennströme. Bei Überlastung des Verbrauchers, beispielsweise beim Einschalten oder Anlaufen, erhöht sich aber die Stromaufnahme und dadurch die elektrische Verlustleistung im Verbraucher. Eine zu lange auftretende Überlast gefährdet den Verbraucher, beispielsweise die Motorwicklungen, durch Übererwärmung. Die in einem solchen Überlastfall durch das Schaltgerät fließenden elektrischen Ströme können deutlich höher als der Nennstrom liegen und werden als Überströme oder Überlastströme bezeichnet. Beim Motoranlauf können die Anlaufströme beispielsweise während der Anlaufzeit einen Wert annehmen, der um bis zum zwölffachen Wert höher liegt als der Nennstrom im normalen Dauerbetrieb.

Ein noch extremerer Gefährdungsfall für den Verbraucher und das Schaltgerät ist ein Kurzschluß im elektrischen Verbraucher oder in den zum Verbraucher führenden Leitungen, beispielsweise durch Isolationsfehler. Im Kurzschlussfall treten sehr hohe Kurzschlussströme auf, die sehr schnell zu einer thermischen Beschädigung und meist zur Zerstörung des Verbrauchers oder von Teilen davon oder der Schaltgeräte selbst führt.

Die Verbraucher und auch, insbesondere bei Verwendung von Halbleiterbauelementen, die Schaltgeräte müssen somit vor über einen zu langen Zeitraum fließenden Überströmen oder Kurzschlußströmen geschützt werden. Dazu werden spezielle Schutzgeräte eingesetzt, die zum Schutz des Verbrauchers vor zu hohen Strömen den Leitungsabzweig vom Versorgungsnetz trennen, falls ein solcher kritischer Strom auftritt. Als Schutzgeräte mit einer solchen Überstrom- oder Kurzschlussstromabschaltung können beispielsweise Sicherungen oder mechanische Schutzschalter mit thermischem und elektromagnetischem Überstromauslöser verwendet werden. Es sind auch überlast- bzw. kurzschlusssichere Schaltgeräte mit Halbleiterbauelementen bekannt. Man kann dabei zwischen aktiv mit einer Hilfsenergie arbeitenden elektronischen Schutzschaltern und passiven, autark arbeitenden, sogenannten eigensicheren elektronischen Schutzschaltern unterscheiden.

Aus *WO 95*/*24055 A1* ist eine elektrische Schalteinrichtung bekannt, bei der ein Halbleiterbauelement mit zwei antiseriell FETs und an beiden Seiten des Halbleiterbauelements jeweils ein Unterbrecherkontakt in einen Leitungszug geschaltet sind. Die Unterbrecherkontakte werden von einem Auslöseglied, das parallel zum Halbleiterbauelement geschaltet ist, ein- oder ausgeschaltet. Zwischen Gate und Source der beiden FETs liegt eine Steuerspannung einer Steuereinrichtung an. Im Leitungszug ist ein Stromsensor angeordnet, mit dem die Steuereinrichtung verbunden ist. Die Steuereinrichtung prüft, wann ein zulässiger Kurzschlussstrom erreicht bzw. überschritten wird und stellt die Steuerspannung für die beiden FETs dann so ein, dass der zulässige Kurzschlussstrom nicht überschritten wird, indem der Innenwiderstand der FETs über die Steuerspannung erhöht wird. Die Steuereinrichtung erzeugt die Steuerspannung mit Hilfe einer Hilfsenergie (Fremdenergie). Das Signal des Stromsensors dient nur zur Auswertung, wann ein Kurzschlussfall vorliegt oder nicht.

Die *WO 95*/*07571 A1* offenbart einen Wechselstromsteller mit zwei antiseriell geschalteten MOSFETs auf Basis von Siliciumcarbid. Jeder SiC-MOSFET ist über eine eigene Gate-Source-Steuerspannung ansteuerbar. Die Gate-Source-Spannung ist nach Angaben in dieser Druckschrift in Durchlassrichtung so groß eingestellt, dass sich eine gewünschte Begrenzung des Drain-Source-Stromes einstellt und im Inversbetrieb nur so groß, dass die inneren Body-Dioden der MOSFETs noch stromlos sind. Durch die Strombegrenzungseigenschaft dieser Schaltung können Kurzschlussströme auf ein akzeptables Niveau begrenzt und durch entsprechend laufend erniedrigte Gates-Source-Spannungen abgesenkt werden. Die Gate-Source-Spannungen werden mit Hilfe einer externen Energiequelle erzeugt.

Aus *DE 196 10 135 C1* ist eine eigensichere, passiv geschützte bzw. schützende elektronische Schalteinrichtung bekannt, die zwei elektrische Anschlüsse zum Anlegen elektrischer Betriebsspannungen, ein Halbleiterbauelement auf Siliciumbasis als Schaltelement und zusätzlich eine hochsperrende Halbleiteranordnung als Schutzelement aufweist. Das Schutzelement umfasst ein erstes Halbleitergebiet eines vorgegebenen Leitungstyps und wenigstens ein weiteres Halbleitergebiet des entgegengesetzten Leitungstyps, zwischen denen jeweils ein p-n-Übergang gebildet ist. Die Halbleitergebiete sind jeweils mit einem Halbleiter mit einer Durchbruchfeldstärke von wenigstens 10⁶ V/cm gebildet, insbesondere Diamant, Aluminiumnitrid (AIN), Galliumnitrid (GaN), Indiumnitrid (InN) und vorzugsweise Siliciumcarbid (SiC), insbesondere der Polytypen 3C, 4H und/oder 6H.

Es ist nun wenigstens ein an den p-n-Übergang angrenzendes Kanalgebiet im ersten Halbleitergebiet des Schutzelements mit dem Silicium-Schaltelement elektrisch in Reihe zwischen die beiden Anschlüsse geschaltet. Das Schaltelement weist bei Betriebsspannungen einer vorgegebenen Polarität einen Durchlasszustand und einen Sperrzustand auf. Der p-n-Übergang des Schutzelements ist elektrisch zwischen die beiden Anschlüsse in Sperrrichtung für die Betriebsspannungen geschaltet. Wenn das Schaltelement in seinem Sperrzustand ist, schnürt die Verarmungszone des wenigstens einen p-n-Übergangs das Kanalgebiet im ersten Halbleitergebiet des Schutzelements ab. Dadurch fällt im Sperrzustand des Schaltelements über der Verarmungszone des p-n-Übergangs bereits der größte Anteil der Betriebsspannung zwischen den beiden Anschlüssen ab. Aufgrund der hohen Durchbruchsfeldstärke von wenigsten 10⁶ V/cm des für die Halbleitergebiete des p-n-Übergangs vorgesehenen Halbleiters kann der p-n-Übergang des Schutzelements deutlich höhere Sperrspannungen tragen als ein in Silicium gebildeter p-n-Übergang mit gleichen Ladungsträgerkonzentrationen und Abmessungen. Die Durchbruchsfeldstärke von Silicium liegt zum Vergleich bei etwa 2 · 10⁵ V/cm. Das Silicium-Schaltelement muss deshalb nur für den übrigbleibenden Teil der Sperrspannung zwischen den beiden Anschlüssen ausgelegt werden. Dies wiederum hat eine deutlich reduzierte Verlustleistung des Silicium-Schaltelements im Durchlassbetrieb zur Folge. Am p-n-Übergang des Schutzelements liegt ferner im anderen Schaltungszweig die gesamte Betriebsspannung zwischen den beiden Anschlüssen als Sperrspannung an. Im Durchlasszustand des Siliciumbauelements wird das Kanalgebiet im ersten Halbleitergebiet des Schutzelements wieder geöffnet und es kann durch das Kanalgebiet nun ein elektrischer Strom zwischen den beiden Anschlüssen fließen.

Als Schaltelement wird ein Silicium-Leistungs-MOSFET, vorzugsweise vom Normally-off-Typ, oder auch ein MESFET (Metal-Semiconductor-Field-Effect-Transistor) vorgeschlagen. Das Schutzelement ist vorzugsweise als vertikaler JFET (Junction-Field-Effect-Transistor) ausgebildet. Die Source des JFET ist mit dem Drain des Silicium-MOSFET kurzgeschlossen. Das Drain des JFET ist mit dem zweiten Anschluss der elektronischen Schalteinrichtung elektrisch verbunden. Das Gate des JFET ist mit dem ersten Anschluss der elektronischen Schalteinrichtung und der Source des Silicium-MOSFET elektrisch kurzgeschlossen. Mit einer solchen bekannten elektronischen Einrichtung, die als Hybrid-Leistungs-MOSFET oder Kaskodeschaltung bezeichenbar ist, können insbesondere Sperrspannungen bis zu 5000 V und Durchlassströme zwischen 5 A und 5000 A erreicht werden, wenn als Halbleitermaterial für die Schutzelement Siliciumcarbid (SiC) verwendet wird. Kombiniert man in einer weiteren Ausführungsform der aus *DE 196 10 135 C1* bekannten elektronischen Einrichtung ein Schutzelement von einem IGBTartigen Hybrid auf Basis von Siliciumcarbid (SiC) mit einem Silicium-MOSFET, so können Sperrspannungen von bis zu 10000 V und Nennströme zwischen 100 A und 1000 A erreicht werden.

Die weitere Druckschrift *DE 198 33 214 C1* offenbart eine als Mesa-Struktur mit Epitaxie-Schichten aufgebaute JFET-Schutzelement, vorzugsweise auf Basis von Siliciumcarbid (SiC), als Schaltelement. Diese hochsperrende JFET-Schutzelement wird besonders für Umrichteranwendungen für drehzahlveränderbare Antriebe oder als Wechselspannungsschalter von Motorabzweigen vorgeschlagen, bei denen die schaltenden Bauelemente "normally off" betrieben werden müssen, d. h. bei Stromausfall automatisch in den sperrenden Zustand übergehen sollen. Dazu wird vorgeschlagen, die hochsperrende JFET-Schutzelement in einer Kaskodeschaltung mit einem Niedervolt-MOSFET bzw. Niedervolt-Smart-MOSFET zu verschalten, wobei der Niedervolt-FET in bekannter Silicium-Technologie hergestellt werden kann.

Sowohl mit der aus *DE 196 10 135 C1* bekannten als auch bei der in der *DE 198 33 214 C1* beschriebenen Kaskodeschaltung ist eine sogenannte eigensichere Schalteinrichtung verwirklicht, die sich und den Leitungsabzweig selbsttätig ohne eine zusätzliche Hilfsenergieversorgung schützt und Kurzschlussströme oder Überlastströme auf den Sättigungsstrom des Schutzelements, insbesondere des JFET, begrenzt.

Ein Problem stellt bei der aus *DE 196 10 135 C1* oder *DE 198 33 214 C1* bekannten Schalteinrichtung die Tatsache dar, dass der beim Anlaufvorgang eines elektrischen Antriebs oder allgemein beim Einschalten eines Verbrauchers benötigte Anlaufstrom oder Einschaltstrom in einem Überlastbereich liegen kann. Hier tritt also ein Fall einer zeitlich und in der Stromstärke begrenzten oder übersehbaren, regulären Überlast als normaler Betriebszustand auf, der im Gegensatz zu irregulären Überlastfällen mit unvorhersagbarer Dauer und Überstromstärke zu tolerieren ist. In den letztgenannten irregulären Überlastfällen soll nun aber das Schutzelement den Strom auf seinen Sättigungsstrom begrenzen, um Schäden am Verbraucher zu verhindern. Legt man deshalb das Schutzelement so aus, dass ein Überlastschutz vor irregulärer Überlastung erreicht wird, so können die vom Verbraucher benötigten Anlauf- oder Einschaltströme von der Schalteinrichtung nicht bereitgestellt oder durchgeschaltet werden, wodurch wiederum ein ordnungsgemäßer Betrieb des Verbrauchers nicht möglich ist. Dimensioniert man dagegen umgekehrt das Schutzelement so, dass der Sättigungsstrom höher ist als der Anlaufstrom oder Einschaltstrom, so schützt das Schutzelement den Verbraucher und das Schaltelement nicht mehr in irregulären Überlastfällen, bei denen mit den Anlaufströmen oder Einschaltströmen vergleichbare Überströme fließen. Das Schutzbauelement ist dann nur für den kurzzeitigen Anlauf- oder Einschaltbetrieb überzudimensionieren. Zum Schutz auch vor irregulären Überlastfällen ist außerdem eine zusätzliche Erkennungs- und Verarbeitungs-Baugruppe erforderlich, die solche Überlastfälle getrennt vom Anlauf- oder Einschaltfall erfasst und beherrscht. Es wäre aber wünschenswert, mit einer einzigen Schutz- oder Schalteinrichtung sowohl die hohen Ströme beim Anlauf oder Einschalten als auch die Strombegrenzung bei Überlast oder Kurzschluss zu beherrschen.

Der Erfindung liegt deshalb die Aufgabe zugrunde, eine Schalteinrichtung und ein Verfahren zum Betreiben einer Schalteinrichtung anzugeben, bei denen die genannten Nachteile beim Stand der Technik vermieden oder zumindest gemildert werden.

Diese Aufgabe wird gemäß der Erfindung gelöst durch eine Schalteinrichtung mit den Merkmalen des Anspruchs 1 bzw. ein Verfahren zum Betreiben einer Schalteinrichtung gemäß dem fakultativ auf Anspruch 1 rückbezogenen Anspruch 33.

Die in den.Ansprüchen 1 und 33 beanspruchte Erfindung geht aus von einer Schalteinrichtung mit wenigstens einem Schaltelement, das zwischen einem ausgeschalteten Zustand und einem eingeschalteten Zustand hin und her schaltbar ist, im allgemeinen über ein an wenigstens einem Schaltanschluss anliegendes entsprechendes Schaltsignal, und mit wenigstens einem Schutzelement, das zum Schaltelement elektrisch in Reihe geschaltet ist und den elektrischen Strom, in einem strombegrenzenden Zustand (stromlimitierenden Zustand, Sättigungszustand), auf einen Maximalstrom (Grenzstrom, Begrenzungsstrom, Sättigungsstrom) begrenzt. Das Schutzelement schützt durch diese Strombegrenzung das Schaltelement im eingeschalteten Zustand vor einer zu hohen thermischen Belastung in einem Gefährdungsfall, bei dem zu hohe prospektive Überströme oder Kurzschlussströme durch das Schaltelement fließen würden und das Schaltelement durch die resultierende Joulesche Verlustwärme thermisch gefährden würden.

Die Erfindung beruht nun auf dem ersten Gedankenschritt, ein Schutzelement zu verwenden mit einem in seinem Wert steuerbaren (einstellbaren, veränderlichen) Maximalstrom und eine Steuerung (Einstellung) des Maximalstromes vorzusehen. Im allgemeinen hängt der Maximalstrom dann von einem an einem Steueranschluss des Schutzelements anliegenden, von Steuermitteln erzeugten Steuersignal ab.

Die Erfindung beruht auf dem zweiten Gedankenschritt, die Steuerung des Maximalstromes so auszubilden, dass der Maximalstrom des Schutzelements zu dem Zeitpunkt, zu dem das Schaltelement in den eingeschalteten Zustand übergeht, oder eine vorgegebenen Zeitdauer nach diesem Einschaltzeitpunkt, wenigstens im zeitlichen Mittel wenigstens einen erhöhten (höheren, angehobenen) Wert annimmt, also erhöht (betragsmäßig vergrößert) wird, falls der Maximalstrom vorher auf einem niedrigeren Wert lag, oder, falls der Maximalstrom sich vorher bereits auf einem erhöhten Wert befand, auf wenigstens einem erhöhten Wert gehalten wird. Damit tritt die strombegrenzende Wirkung des Schutzelements, gleichzeitig mit oder zeitversetzt zu dem Einschalten des Schaltelements, erst bei entsprechend größeren Strömen auf. Durch Anpassung des Maximalstromes des Schutzelements können somit beim oder nach dem Einschalten des Schaltelements auftretende höhere Anlaufströme oder Einschaltströme als reguläre Überlast zugelassen werden.

Dabei genügt es, wenn der Maximalstrom nur im zeitlichen Mittel höher liegt, da es bei der vom Schutzelement durchgelassenen elektrischen Energie nur auf das zeitliche Integral ankommt und deshalb kurzzeitig in einzelnen Zeitintervallen niedrigere Werte des Maximalstromes keine Rolle spielen, solange diese niedrigeren Werte durch höhere Werte in anderen Zeitintervallen integral ausgeglichen werden. Dadurch sind neben einer einfachen Umschaltung zwischen zwei diskreten Werten des Maximalstromes, nämlich einem höheren Wert für den Startbetrieb und einem niedrigen Wert für den Dauerbetrieb, auch eine Vielzahl anderer zeitlicher Verläufe des Maximalstromes denkbar, beispielsweise kontinuierliche (stetige) und/oder monoton oder streng monoton ansteigende oder abfallende und/oder mit einer superponierten Schwingung auf- oder absteigende zeitabhängige Verläufe.

Später, nach Beendigung eines Anlauf- oder Einschaltvorganges (Startbetriebs), werden auftretende Überströme in irregulären Überlastfällen wieder stärker begrenzt, indem der Maximalstrom dann wieder so gesteuert wird, dass der Maximalstrom in einem niedrigeren Normalbereich liegt, also abgesenkt (verringert, erniedrigt) wird.

Durch diese Steuerung des Maximalstromes und damit der Stromtragfähigkeit des Schutzelements gemäß der Erfindung können also mit einer einzigen Schalteinrichtung aus einem Schaltelement und einem Schutzelement sowohl ein Überlast- und Kurzschlussschutz als auch Anlauf- oder Einschaltvorgänge berücksichtigt werden.

Vorteilhafte Ausgestaltungen, Weiterbildungen und Anwendungen der Schalteinrichtung und des Verfahrens ergeben sich aus den vom Anspruch 1 bzw. Anspruch 33 jeweils abhängigen Ansprüchen.

Der Maximalstrom kann in einer ersten Ausführungsform sprunghaft auf einen einzigen, diskreten höheren Wert erhöht werden oder auch in einer zweiten, allgemeiner einsetzbaren Ausführungsform auch gemäß einem vorgegebenen Zeitprofil, insbesondere als vorzugsweise stetige Funktion der Zeit, verändert werden, wobei die dann sich verändernden Werte des Maximalstromes zumindest überwiegend oder im zeitlichen Mittel über dem vor dem Einschalten des Schaltelements eingestellten Maximalstrom liegen sollen. Vorzugsweise wird der Maximalstrom des Schutzelements für eine vorgegebene oder vorgebbare Zeitdauer erhöht gehalten.

Diese vorgegebene oder vorgebbare Zeitdauer und/oder das vorgegebene Zeitprofil und/oder die Höhe des erhöhten Maximalstromes werden in der Regel den gewünschten entsprechenden Größen beim durch einen erhöhten Energiebedarf gekennzeichneten Anlauf oder Start eines der Schalteinrichtung nachgeschalteten elektrischen Verbrauchers, insbesondere eines elektrischen Antriebs, angepasst, also das Zeitintervall der gewünschten Anlaufzeit oder Einschaltzeit (Startzeit), der erhöhte Wert des Maximalstromes dem Anlauf- oder Startstrom und das Zeitprofil ggf. einem zeitlich sich ändernden Energiebedarf, um eine möglichst gute Anpassung zu erreichen. Die entsprechende Steuerung ist mit einer geeigneten Treiberschaltung als Steuermittel für das Schutzelement leicht zu realisieren.

Ein besonders einfacher Zeitverlauf für den Maximalstrom des Schutzelements ist ein binäres, sprunghaftes (kurze Schaltflanken) Umschalten zwischen genau einem niedrigeren Wert und genau einem erhöhten Wert. Es kann aber auch zwischen dem niedrigen und dem hohen Wert des Maximalstromes kontinuierlich (mit einer gewissen Zeitkonstante und größeren Übergangsbereichen) hin- und/oder hergeschaltet werden, insbesondere beim Zurücksetzen des Maximalstromes auf den niedrigeren Wert.

Nach Beendigung der Phase, während der der Maximalstrom des Schutzelements erhöht wird oder ist, wird der Maximalstrom wieder reduziert. Der reduzierte Wert des Maximalstromes ist nun so gewählt, dass ein zuverlässiger Schutz vor irregulären Überströmen (Überlastschutz und Kurzschlussschutz) gewährleistet ist. Dazu wird der wenigstens eine niedrigere Wert des Maximalstromes des Schutzelements dem maximal zulässigen Überstrom des elektrischen Verbrauchers im Betrieb nach Beendigung des Anlaufes oder Startes des elektrischen Verbrauchers angepasst oder maximal so groß wie dieser gewählt.

Der wenigstens eine erhöhte Wert des Maximalstromes des Schutzelements ist vorzugsweise deutlich niedriger gewählt als ein prospektiver Kurzschlussstrom, um nicht während der Anlauf- oder Startphase, bei der das Schutzelement stromdurchlässiger ist, von einem Kurzschluss überrascht zu werden.

Das Verhältnis aus dem wenigstens einen erhöhten Wert und dem wenigstens einen niedrigeren Wert des Maximalstromes des Schutzelements ist vorzugsweise wenigstens 2, vorzugsweise wenigstens 3.

Die Steuermittel können in einer bevorzugten Ausführungsform zur Bereitstellung des Steuersignals zur Erhöhung des Maximalstromes des Schutzelements wenigstens einen aufladbaren Kondensator und vorzugsweise einen zugeschalteten, vorzugsweise parallelgeschalteten, Entladewiderstand umfassen. Der Kondensator wird nun beim oder nach dem Einschalten des Schaltelements gemäß einer vorgegebenen Zeitkonstante entladen und erzeugt dadurch ein entsprechend, im allgemeinen exponentiell, abfallendes Steuersignal für das Schutzelement. Später, vorzugsweise beim Ausschalten des Schaltelements oder nach Ablauf einer vorbestimmten Zeitdauer nach dem Ausschalten des Schaltelements, wird der Kondensator wieder aufgeladen mittels einer Hilfsenergiequelle (Auflademittel).

Zum Trennen von Entladevorgang und Aufladevorgang sind in einer vorteilhaften Ausführungsform zwischen die Hilfsenergiequelle und den Kondensator ein Aufladeschalter und/oder zwischen den Kondensator und den Steueranschluss des Schutzelements sowie auch den Entladewiderstand ein Entladeschalter geschaltet. Aufladeschalter und/oder Entladeschalter sind zusammen mit dem Schaltelement schaltbar. Der Aufladeschalter ist dabei in seinem ausgeschalteten Zustand und/oder der Entladeschalter, gegebenenfalls mit einer vorgegebenen Zeitverzögerung, in seinem eingeschalteten Zustand, wenn das Schaltelement in seinem eingeschalteten Zustand ist. Ist das Schaltelement dagegen in seinem ausgeschalteten Zustand, so sind der Aufladeschalter in seinem eingeschalteten Zustand und/oder der Entladeschalter in seinem ausgeschalteten Zustand. Für dieses gemeinsame Schalten von Aufladeschalter und/oder Entladeschalter mit dem Schaltelement sind die Schaltsignalerzeugungsmittel, die am Schaltanschluss des Schaltelements ein Schaltsignal zum Umschalten des Schaltelements anlegen, auch mit zugehörigen Schalteranschlüssen von Entladeschalter und Aufladeschalter verbunden.

In einer besonders vorteilhaften Ausführungsform umfasst der Aufladeschalter und/oder der Entladeschalter der Steuermittel wenigstens einen Transistor, vorzugsweise einen MISFET (Metall-Insulator-Semiconductor-Field-Effect-Transistor), insbesondere einen MOSFET. Das Schaltsignal ist dann ein Steuerpotential oder eine Steuerspannung zwischen Gate und Source. Besonders vorteilhaft ist die Verwendung eines selbstsperrenden (normally-off) MISFET oder MOSFET (Anreicherungstyp). Ein solcher selbstsperrender MISFET ist bei einer Steuerspannung von 0 V im sperrenden (ausgeschalteten) Zustand und benötigt zum Einschalten oder Übergang in den Durchlasszustand eine aktive Schalt- oder Steuerspannung, die betragsmäßig größer als 0 V ist und im allgemeinen oberhalb einer Schwellspannung liegen muss.

Der Steuertransistor kann auch ein (stromgesteuerter) bipolarer Transistor (vom npn- oder pnp-Typ) oder ein (spannungsgesteuerter) IGBT (Insulated-Gate-Bipolar-Transistor) sein. Ferner kann als Steuerschalter auch ein anderes schaltfähiges Bauelement oder Halbleiterbauelement verwendet werden, beispielsweise ein Thyristor oder ein MCT (MOS-Controlled-Thyristor).

Besonders geeignet als Schutzelement ist ein elektronisches Bauelement, insbesondere ein Halbleiterbauelement, das ein Sättigungsverhalten zeigt, bei dem also in der Strom-Spannungs-Kennlinie im Durchlassbereich der Strom sich bei steigender Spannung einem Sättigungsstrom (maximalen Stromwert) als Maximalstrom nähert oder diesen annimmt. Der Maximalstrom oder Sättigungsstrom des Schutzelements ist vorzugsweise kleiner, beispielsweise um einen Faktor von wenigstens 2 oder sogar wenigstens 3, als der thermische Grenzstrom des Schaltelements. Der thermische Grenzstrom ist der maximal zulässige Strom, bei dem noch keine thermische Zerstörung stattfindet. Das Schutzelement übernimmt durch seine stromlimitierende Eigenschaft in einem Überlast- oder Kurzschlussfall (Gefährdungsfall) den überwiegenden Anteil der an der Reihenschaltung abfallenden Betriebsspannung und entsprechend auch den überwiegenden Anteil der Jouleschen Verluste. Bei im Normalbetrieb (Nennbetrieb, Dauerbetrieb) betriebenem Verbraucher ohne Überlast und Kurzschluss und den entsprechenden, deutlich geringeren Nennströmen soll das Schutzelement dagegen möglichst geringe Durchlassverluste haben. Das Verhältnis aus der am Schutzelement abfallenden Spannung und der am Schaltelement abfallenden Spannung und somit auch das Verhältnis aus der im Schutzelement freiwerdenden Jouleschen Verlustleistung und der im Schaltelement freiwerdenden Jouleschen Verlustleistung ist deshalb im Nennbetrieb deutlich kleiner gewählt als im Gefährdungsfall oder, anders ausgedrückt, der Anteil des vom Schutzelement übernommenen Spannungsabfalls und damit der Jouleschen Wärmeleistung nimmt wegen der Strombegrenzung im Gefährdungsfall gegenüber dem Nennbetrieb entsprechend stark zu. Es kann insbesondere auch der absolute Wert des am Schaltelements abfallenden Teils der Betriebsspannung unterhalb eines vorgegebenen Maximalwertes, beispielsweise 100 V oder auch 50 V, gehalten werden.

Da das Schutzelement im Gefährdungsfall und auch in der Anlauf- oder Startphase somit eine möglichst hohe thermische Belastbarkeit aufweisen sollte, ist das elektronische Schutzelement vorzugsweise auf Basis wenigstens eines Halbleiters gebildet, der eine Durchbruchsfeldstärke von wenigstens 10⁶ V/cm und/oder einen Bandabstand von wenigstens 2 eV umfasst und somit zum Sperren höherer Spannungen geeignet ist. Dadurch kann das Schutzelement einen besonders hohen Anteil der Betriebsspannung im Gefährdungsfall tragen oder bei vorgegebenem Maximalstrom der Strombegrenzung für höhere Betriebsspannungen eingesetzt werden. Geeignete Halbleitermaterialien sind Siliciumcarbid (SiC), insbesondere vom β-Polytyp (3C)-, oder von einem α-Polytyp, beispielsweise 15R-, 4H- oder 6H-Polytyp, Galliumnitrid (GaN), Diamant, Aluminiumnitrid (AlN) und Indiumnitrid (InN). Das bevorzugte Halbleitermaterial ist Siliciumcarbid (SiC) wegen seiner extrem niedrigen Eigenladungsträgerkonzentration, seiner hohen Durchbruchsfestigkeit, geringen Verlustleistung, hohen Temperaturbeständigkeit, chemischen Resistenz und hohen Wärmeleitfähigkeit. Das Schutzelement kann aber auch aus einem anderen Halbleiter, beispielsweise Silicium, gebildet sein.

Auch das Schaltelement ist vorzugsweise mit einem Halbleiterbauelement gebildet. Da für das Schaltelement ein möglichst gutes Schaltverhalten im Vordergrund steht und weniger die Spannungsfestigkeit, die vom Schutzelement weitgehend übernommen wird, wird das elektronische Schaltelement vorzugsweise auf Basis eines oder mehrerer Halbleiter aus der Silicium (Si), Galliumarsenid (GaAs) und Germanium (Ge) umfassenden Gruppe von Halbleitern aufgebaut. Grundsätzlich ist auch SiC als Halbleitermaterial für das Schaltelement möglich.

Das Schutzelement kann die anliegende Sperrspannung über wenigstens einen in Sperrrichtung betriebenen p-n-Übergang und/oder wenigstens einen Schottky-Übergang tragen, bei denen jeweils die Bildung von Verarmungszonen zum Sperren der Spannung charakteristisch ist.

Bevorzugte Bauelementstrukturen für das Schutzelement und/oder das Schaltelement sind JFET(Junction-Field-Effect-Transistor)-, MESFET(Metall-Semiconductor-Field-Effect-Transistor)- und/oder MISFET-, insbesondere MOSFET-, Strukturen.

In einer besonders vorteilhaften Kombination ist das Schutzelement mit einer JFET-Struktur oder einer MESFET-Struktur und das Schaltelement mit einer MISFET-Struktur ausgestattet. Es sind dann in der Arbeitsschaltung der Gateanschluss der JFET-Struktur oder MESFET-Struktur des Schutzelements, vorzugsweise über den Entladewiderstand in Abwandlung zur bekannten Kaskodeschaltung, mit dem Sourceanschluss der MISFET-Strüktur des Schaltelements verbunden und der Sourceanschluss der JFET-Struktur oder MESFET-Struktur des Schutzelements mit dem Drainanschluss der MISFET-Struktur des Schaltelements verbunden.

Die Schalteinrichtung ist in einer vorteilhaften Anwendung in einen Leitungsabzweig, insbesondere einen Leitungsabzweig eines elektrischen Versorgungsnetzes wie eines Niederspannungsnetzes (typischerweise zwischen 230 V und 690 V Effektivwert), vor einen elektrischen Verbraucher geschaltet und schaltet einerseits die Nennströme für den Verbraucher und trennt andererseits den Verbraucher im Überlastfall oder Kurzschlussfall rechtzeitig von dem Netz und verhindert so Schäden am Verbraucher. Wenn die an der Reihenschaltung aus Schaltelement und Schutzelement anliegende Betriebsspannung eine zeitlich veränderliche, in der Polarität wechselnde (alternierende), beispielsweise periodisch alternierende, Spannung (Wechselspannung), wie sie üblicherweise von elektrischen Energieversorgungsnetzen oder elektrischen Generatoren bereitgestellt wird, ist, so werden vorzugsweise zwei Schalteinrichtungen gemäß der Erfindung antiseriell, also in Reihe mit entgegengesetzter Schaltrichtung oder Polarität, in den Leitungsabzweig geschaltet.

Zur weiteren Erläuterung der Erfindung wird auf die Zeichnung Bezug genommen, in deren
- FIG 1: eine Ausführungsform einer Schalteinrichtung mit einem Schutzelement mit steuerbarem Sättigungsstrom,
- FIG 2: ein Diagramm mit Strom-Spannungs-Kennlinien mit verschiedenen Sättigungsströmen des Schutzelements gemäß FIG 1,
- FIG 3: ein Diagramm mit zwei zeitlichen Verläufen für den Maximalstrom Iₘₐₓ des JFET-Schutzelements gemäß FIG 1 und
- FIG 4: ein Diagramm mit einem weiteren zeitlichen Verlauf des Maximalstromes Iₘₐₓ des JFET-Schutzelements gemäß FIG 1

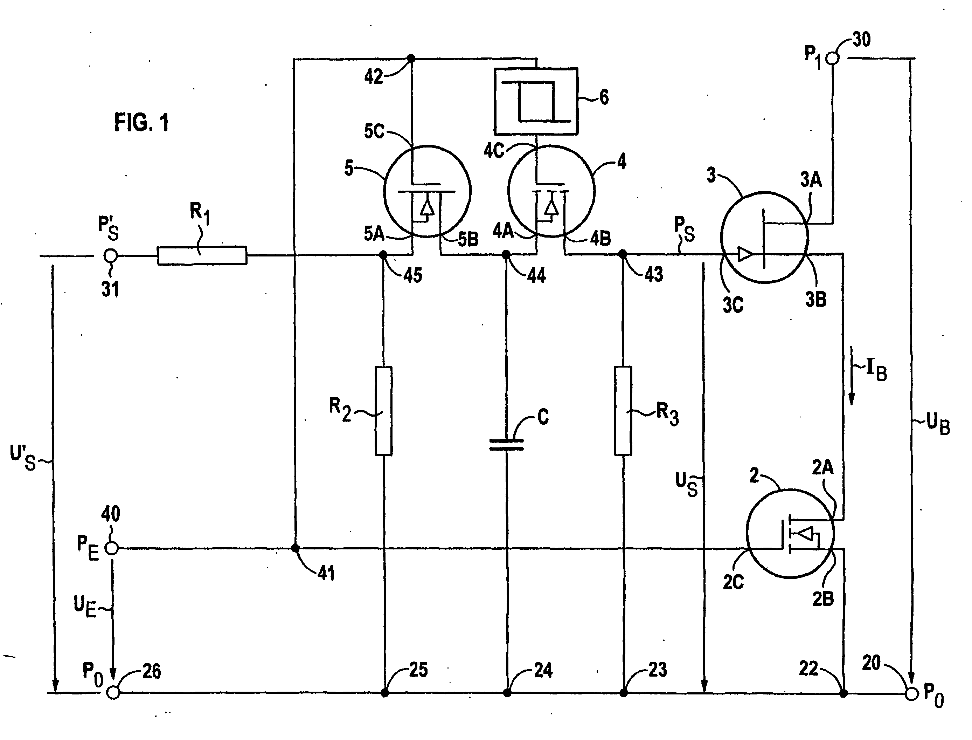

jeweils schematisch dargestellt sind. Einander entsprechende Teile oder Größen sind in FIG 1 bis FIG 4 mit denselben Bezugszeichen versehen.

Die Schalteinrichtung gemäß FIG 1 umfasst eine Kaskodeschaltung aus einem JFET, vorzugsweise einem vertikalen JFET oder V-JFET, als Schutzelement 3 und einem MOSFET als Schaltelement 2. Die Source 2B des MOSFET-Schaltelements 2 ist mit einem mit dem Anschluss 20 verbundenen Schaltpunkt 22, die Drain 2A des MOSFET-Schaltelements 2 mit der Source 3B des JFET-Schutzelements 3 und die Source 3A des JFET-Schutzelements 3 mit dem Anschluss 30 verbunden. Das Gate (Steueranschluss) 3C des JFET-Schutzelements 3 ist mit einem Schaltpunkt 43 verbunden, der über einen zwischengeschalteten Entladewiderstand R₃ mit einem Schaltpunkt 23 verbunden ist, der wiederum mit dem Schaltpunkt 22 kurzgeschlossen ist. Es sind also die Source-Drain-Strecken des JFET-Schutzelements 3 und des MOSFET-Schaltelements 2 in Reihe zueinander geschaltet und diese Reihenschaltung zur Reihenschaltung aus Source-Gate-Strecke des JFET-Schutzelements 3 und Entladewiderstand R₃ parallel zwischen die Anschlüsse 20 und 30 geschaltet.

Die Schaltpunkte 22 und 23 und die weiteren Schaltpunkte 24 und 25 liegen elektrisch ebenso wie der Anschluss 20 auf gleichem Potential P₀. Der zweite Anschluss 30 liegt auf einem Potential P₁. Zwischen den zwei elektrischen Anschlüssen 20 und 30 ist eine Betriebsspannung U_{B} = P₁ - P₀ angelegt oder anlegbar. Das Potential P₀ ist im allgemeinen im wesentlichen konstant, insbesondere Erd- oder Massepotential, während das Potential P₁ der aktiven Phase entspricht.

Das am Gate 3C des JFET-Schutzelements 3 anliegende Steuerpotential ist mit P_{S} bezeichnet, die über dem Entladewiderstand R₃ abfallende Spannung als Steuerspannung des JFET-Schutzelements 3 mit U_{S} = P_{S} - P₀.

An das Gate 2C des MOSFET-Schaltelements 2 ist ein Schaltpotential P_{E} eines Schalteingangs 40 angelegt. Die Gate-Source-Spannung des MOSFET-Schaltelements 2 ist die entsprechende Schaltspannung U_{E} = P_{E} - P₀ zum Schalten des mit dem MOSFET gebildeten Schaltelements 2. Das MOSFET-Schaltelement 2 ist vom selbstsperrenden Typ (normally-off-Typ), so dass bei einer Schaltspannung U_{E} = 0 Volt (V) das MOSFET-Schaltelement 2 im ausgeschalteten Zustand ist und erst bei einer Schaltspannung U_{E}, die größer als ein bestimmter Schwellwert liegt, das MOSFET-Schaltelement 2 aufgesteuert wird und in seinen leitenden oder eingeschalteten Zustand übergeht.

Bei eingeschaltetem Schaltelement 2 wird durch Ladungsträgerinjektion auch der Sperrzustand im Kanalgebiet des JFET-Schutzelements 3 aufgehoben und es kann ein Betriebsstrom I_{B} durch die Reihenschaltung aus JFET-Schutzelement 3 und MOSFET-Schaltelement 2 fließen.

Diese Kaskodeschaltung gemäß FIG 1 unterscheidet sich von der in *DE 196 10 135 C1* beschriebenen bekannten Kaskodeschaltung in dem zwischen Gate 3C des JFET-Schutzelements 3 und die Source 2B des MOSFET-Schaltelements 2 geschalteten Entladewiderstand R₃. Ausführungsbeispiele für den JFET-Schutzelement 3 sind in der *DE 196 10 135 C1* und auch in der *DE 198 33 214 C1* beschrieben.

Das Verhalten des Schutzelements (JFET) 3 bei Anliegen einer Betriebsdurchlassspannung U_{B} zwischen Drain 3A und Source 3B ist abhängig von dem durch das JFET-Schutzelement 3 fließenden elektrischen Betriebsstrom I_{B} sowie der am Gate 3C anliegenden Steuerspannung U_{S}, die unmittelbar korreliert ist zur Gate-Source-Spannung des JFET-Schutzelements 3.

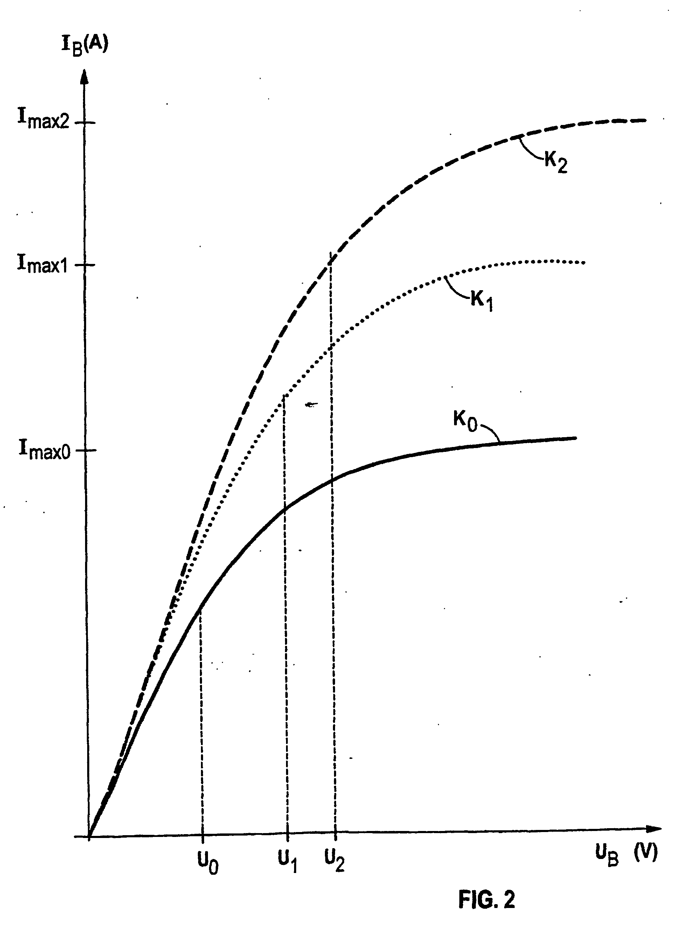

Verschiedene Strom-Spannungs-Kennlinien des JFET-Schutzelements 3 für unterschiedliche Steuerspannungen U_{S} sind in FIG 2 dargestellt. In dem Diagramm gemäß FIG 2 ist der zwischen Drain 3A und Source 3B durch das JFET-Schutzelement 3 fließende Betriebsstrom I_{B} in Abhängigkeit von der zwischen Drain 3A und Source 3B anliegenden Drain-Source-Spannung U_{B}. Es sind eine Kennlinie K₀ für die Funktion I_{B}(U_{B}) bei einer Steuerspannung U_{S} = 0 V, eine zweite Kennlinie K₁ für die Funktion I_{B} (U_{B}) bei einer Steuerspannung U_{S} = U_{S1} > 0 V und eine dritte Kennlinie K₂ bei einer Steuerspannung U_{S} = U_{S2} > U_{S1} gezeigt.

Bei normalen Betriebsströmen (Nennströmen) im Nennbetrieb hat das JFET-Schutzelement 3 einen niedrigen Durchlasswiderstand und eine praktisch lineare ohmsche Kennlinie. Dieser ohmsche Bereich reicht bei der Kennlinie K₀ von U_{B} = 0 V bis etwa U_{B} = U₀, bei der Kennlinie K₁ von U_{B} = 0 V bis etwa U_{B} = U₁ und bei der Kennlinie K₂ von U_{B} = 0 V bis etwa U_{B} = U₂. Es ist zu erkennen, dass die obere Intervallgrenze des ohmschen Bereiches mit steigender Steuerspannung U_{S} ebenfalls zunimmt, also gilt U₂ > U₁ > U₀.

Bei weiter steigendem Betriebsstrom I_{B} bzw. weiter steigendem Betriebsspannungsanteil U_{B} am JFET-Schutzelement 3 nimmt die Ausdehnung der Verarmungszone des oder der p-n-Übergänge zu und damit die Stromtragfähigkeit des Kanalgebietes des JFET-Schutzelements 3 ab. Der Durchlasswiderstand nimmt dadurch zu und die Steigung der Kennlinie immer mehr ab, Bei Erreichen eines bestimmten kritischen Stromwertes (Sättigungsstrom) geht das JFET-Schutzelement 3 durch vollständige Abschnürung des Kanalgebietes in Sättigung und bleibt bei gleichbleibender oder auch weiter steigender Spannung auf dem Sättigungsstromwert als Maximalstrom Iₘₐₓ. Dieser Sättigungsstrom Iₘₐₓ nimmt mit steigender Steuerspannung U_{S} zu und ist bei der Kennlinie K₀ mit Iₘₐₓ₀, bei der Kennlinie K₁ mit Iₘₐₓ₁ und bei der Kennlinie K₂ mit Iₘₐₓ₂ bezeichnet. Es gilt also Iₘₐₓ₀ < Iₘₐₓ₁ < Iₘₐₓ₂.

Das JFET-Schutzelement 3 begrenzt somit den fließenden Strom auf einen Maximalstrom Iₘₐₓ, der von dem am Steueranschluss (Gate) 3C des Schutzelements 3 anliegenden Steuersignal (Potential) P_{S} und der entsprechenden Steuerspannung U_{S} abhängt. Diese stromlimitierende Eigenschaft wird für die Überstrom-Schutzfunktion ausgenutzt. Der Maximalstrom Iₘₐₓ des Schutzelements 3 wird dazu typischerweise auf einen maximal erlaubten Überlaststrom eines nicht dargestellten elektrischen Verbrauchers eingestellt, der der Schalteinrichtung am Anschluss 30 nachgeschaltet wird oder ist. Dadurch schützt das Schutzelement 3 den elektrischen Verbraucher sowie das Schaltelement 2 vor nicht vorhergesehenen, im Dauerbetrieb möglicherweise auftretenden Überlastsituationen (irreguläre Überlastfälle) und Kurzschlusssituationen.

Jedoch treten beim Anlaufbetrieb eines elektrischen Motors oder Antriebs oder allgemein im Einschalt- oder Starbetrieb eines elektrischen Verbrauchers deutlich über den Nennströmen im Dauerbetrieb liegende Anlaufströme oder Startströme auf, um dem Antrieb bzw. Verbraucher eine höhere Energie zur Verfügung zu stellen. Diese Anlaufströme oder Startströme liegen häufig über den maximal erlaubten Überlastströmen im Dauerbetrieb, stellen also eigentlich nicht erlaubte Überströme dar. Das Schutzelement 3 würde deshalb bei einem festeingestellten Maximalstrom die erforderlichen Anlaufströme oder Startströme gar nicht zulassen, so dass ein ordnungsgemäßer Anlauf- oder Startbetrieb für den Antrieb bzw. Verbraucher behindert oder gar ausgeschlossen wäre.

Aus diesem Grund wird gemäß der Erfindung während des Anlaufvorganges oder Startvorganges des elektrischen Verbrauchers temporär der Maximalstrom Iₘₐₓ des Schutzelementes 3 (Sättigungsstrom des JFET) erhöht, um die höheren Anlaufströme oder Startströme durchzulassen. Dazu wird über ein einstellbaren und der jeweiligen Anwendung entsprechenden Zeitraum das Gate 3C des JFET-Schutzelements 3 positiv vorgespannt, also ein Steuerpotential P_{S} > P₀ oder eine Steuerspannung US > 0 V angelegt. Dies führt, wie anhand des Diagramms in FIG 2 bereits erläutert wurde, zu einer deutlichen Erhöhung des Sättigungsstromes oder Maximalstromes Iₘₐₓ und senkt darüber hinaus die Verluste im Schutzelement 3 während des Anlauf- oder Startvorganges wegen dessen niedrigerem Durchlasswiderstand (Ein-Widerstand). Nach Abschluss des Anlauf- oder Startprozesses wird das JFET-Schutzelement 3 auf seine normale Kennlinie zurückgesetzt, in dem die Gate-Spannung U_{S} wieder auf 0 V (Volt) zurückgeführt wird, und kann dann weitere kritische Zustände im Normalbetrieb (Nennbetrieb) sicher abfangen. Dadurch müssen die Bauelemente für das Schutzelement 3 und das Schaltelement 2 nicht mehr überdimensioniert werden, da der Abstand von Nennstrom zu Anlaufstrom bzw. Startstrom verringert wird.

FIG 1 zeigt eine spezielle, durch ihren einfachen Aufbau bestechende Schaltung zur Erzeugung eines Steuerpotentials P_{S} am Steueranschluss 3C des Schutzelements 3 zur Erhöhung des Maximalstromes (Sättigungsstromes) Iₘₐₓ des Schutzelements (JFET) 3. Die Steuerschaltung legt an den Steueranschluss 3C (Gate) des JFET-Schutzelements 3 zur Anhebung des Maximalstromes Iₘₐₓ ein positives Steuerpotential P_{S} oder eine positive Steuerspannung U_{S} an. Außer der Steuerschaltung gemäß FIG 1 sind aber grundsätzlich auch andere Steuerschaltungen oder Treiberschaltungen möglich, um zusätzlichen Strom über das Gate 3C des JFET-Schutzelements 3 bereitzustellen. Die Steuerschaltung gemäß FIG 1 ist nun wie folgt aufgebaut.

An dem Schaltpunkt 43, der mit dem Steueranschluss 3C des Schutzelements 3 direkt verbunden ist, sind parallel zueinander der Entladewiderstand R₃ und ein Entladeschalter 4 angeschlossen. Als Entladeschalter 4 ist ein selbstsperrender MOSFET vorgesehen, dessen Drain 4B mit dem Schaltpunkt 43 verbunden ist und dessen Source 4A mit einem weiteren Schaltpunkt 44 verbunden ist. Zwischen diesen weiteren Schaltpunkt 44 und den Schaltpunkt 24, der auf dem Potential P₀ liegt, ist ein Steuerkondensator C geschaltet. Ebenfalls mit dem Schaltpunkt 44 elektrisch verbunden ist ein Aufladeschalter 5, der vorzugsweise als selbstleitender MOSFET ausgebildet ist und mit seinem Drain 5B mit dem Schaltpunkt 44 sowie mit seiner Source 5A mit einem weiteren Schaltpunkt 45 elektrisch verbunden ist. Auf den Schaltpunkt 45 ist über einen Eingangswiderstand R₁ ein Eingangspotential P_{S}' geschaltet, das an einem Steuereingang 31 als Hilfsenergie anliegt. Die zwischen dem Steuereingang 31 und dem Schaltpunkt 26, der auf dem Potential P₀ liegt, anliegende Eingangsspannung ist U_{S}' = P_{S}' - P₀. Die Eingangsspannung U_{S}' kann beispielsweise +12 V betragen. Die über den Schaltpunkt 45 miteinander verbundenen Eingangswiderstand R₁ und Entkopplungswiderstand R₂ bilden einen Spannungsteiler, über den am Entkopplungswiderstand R₂ eine niedrigere Spannung, beispielsweise 2,5 V, anliegt.

Es ist nun das Schaltpotential P_{E} am Schalteingang 40, das am Schaltanschluss 2C des Schaltelements 2 anliegt, über einen Schaltpunkt 41 sowie einen weiteren Schaltpunkt 42 auch parallel an den Steueranschluss 5C des Aufladeschalters 5 sowie den Steueranschluss 4C des Entladeschalters 4 angeschlossen. Zwischen dem Schaltpunkt 42 und dem Steueranschluss 4C des Entladeschalters 4 kann außerdem, wie dargestellt, ein Verzögerungsglied 6 geschaltet sein.

Wenn die Schaltspannung U_{E}, die der Gate-Source-Spannung des MOSFET-Schaltelements 2 entspricht, unterhalb der Schwellspannung des MOSFET-Schaltelements 2 liegt, insbesondere also 0 V, beträgt, so ist das Schaltelement 2 in seinem ausgeschalteten Zustand und, spätestens nach Ablauf der durch das Verzögerungsglied 6 bewirkten Zeitverzögerung, auch der Entladeschalter 4 in seinem sperrenden Zustand. Für den selbstleitenden Aufladeschalter 5 ist dagegen das gleiche Steuerpotential P_{E}, das für den Entladeschalter 4 ein Ausschaltsignal ist, ein Einschaltsignal. Der Aufladeschalter 5 ist deshalb in seinem leitenden oder eingeschalteten Zustand, wenn auch das Schaltelement 2 im ausgeschalteten Zustand ist. Dadurch ist zwischen den Anschlüssen 5A und 5B des Aufladeschalters 5 eine leitende Verbindung hergestellt, so dass über den Steuereingang (Hilfsenergiequelle) 31 der Steuerkondensator C aufgeladen wird, bis die an dessen Kondensatorflächen anliegende Spannung der über dem Entkopplungswiderstand R₂ abfallenden Spannung entspricht.

Wenn nun das Schaltpotential P_{E} am Schalteingang 40 umschaltet auf einen Wert, bei dem die Schaltspannung U_{E} größer als die Schwellspannung des Schaltelements 2 ist, so wird das Schaltelement 2 eingeschaltet und zugleich der Aufladeschalter 5 abgeschaltet. Die Kennlinie des Aufladeschalters 5 ist entsprechend gewählt, so dass das gleiche Schaltpotential P_{E}, das das MOSFET-Schaltelement 2 aufsteuert, :den MOSFET-Aufladeschalter 5 ausschaltet, so dass der Aufladeschalter 5 die Schaltpunkte 45 und 44 voneinander entkoppelt. Zugleich schaltet das Schaltpotential P_{E}, das das Schaltelement 2 einschaltet, auch über das Verzögerungsglied zeitverzögert den Entladeschalter 4 ein. Die Zeitverzögerung über den Verzögerungsbaustein 6 ist nicht unbedingt erforderlich, gewährleistet aber eine saubere Trennung zwischen dem Ausschalten des Aufladeschalters 5 und dem Einschalten des Entladeschalters 4. Da nunmehr der Entladeschalter 4 in seinem leitenden Zustand ist, ist zwischen den Anschlüssen 4A und 4B des Entladeschalters 4 eine leitende Verbindung zwischen den Schaltpunkten 44 und 43 hergestellt. Die auf dem Kondensator C gespeicherten Ladungen können nun über den Entladewiderstand R₃ abfließen. Diese Entladung des Steuerkondensators C führt zu einem Steuerpotential P_{S} am Steueranschluss 3C des Schutzelements 3 und einer entsprechenden Steuerspannung U_{S} = P_{S} - P₀. Durch die Wahl der Kapazität des Steuerkondensators C und des elektrischen Widerstandswertes des Entladewiderstandes R₃ kann die Entladezeit und damit der zeitliche Verlauf des Steuerpotentials P_{S} am Steueranschluss 3C des Schutzelements 3 eingestellt werden. Das gegenüber P₀ positive Steuerpotential P_{S} führt nun zu einer Aufsteuerung der Verarmungszone und einer Erweiterung des Kanalgebietes des JFET-Schutzelements 3, so dass der zwischen den Anschlüssen 3A und 3B des JFET-Schutzelements 3 fließende Betriebsstrom I_{B} größere Werte annehmen kann. Zugleich wird der Sättigungsstrom oder Maximalstrom Iₘₐₓ des JFET-Schutzelements 3 erhöht und der ohmsche Bereich und damit der Durchlasswiderstand für unter dem Sättigungsstrom liegende Ströme verringert.

Mit anderen Worten ist also im ausgeschalteten Zustand des Schaltelements 2 der Aufladeschalter 5 geöffnet und über den Spannungsteiler mit R₁ und R₂ wird der Steuerkondensator C geladen. Der Entladeschalter 4 ist geschlossen, so dass das Gate 3C des JFET-Schutzelements 3 über den Entladewiderstand R₃ auf dem vorzugsweise konstanten Potential P₀ liegt. Wird nun die Kaskode eingeschaltet, also das Schaltelement 2 in seinen eingeschalteten Zustand gebracht, so schließt der Aufladeschalter 5 und entkoppelt den Spannungsteiler R₁ und R₂ von dem Steuerkondensator C. Über den Verzögerungsbaustein 6 wird der Entladeschalter 4 geöffnet. Damit liegt der Steuerkondensator C am Gate 3C des JFET-Schutzelements 3 an und spannt dieses vor. Über die RC-Zeitkonstante aus dem Entladewiderstand R₃ und dem Steuerkondensator C entlädt sich der Steuerkondensator C und senkt die Vorspannung langsam ab. Durch eine geeignete Wahl des Entladewiderstandes R₃ und des Steuerkondensators C kann die gewünschte Zeit den jeweiligen Anforderungen angepasst werden.

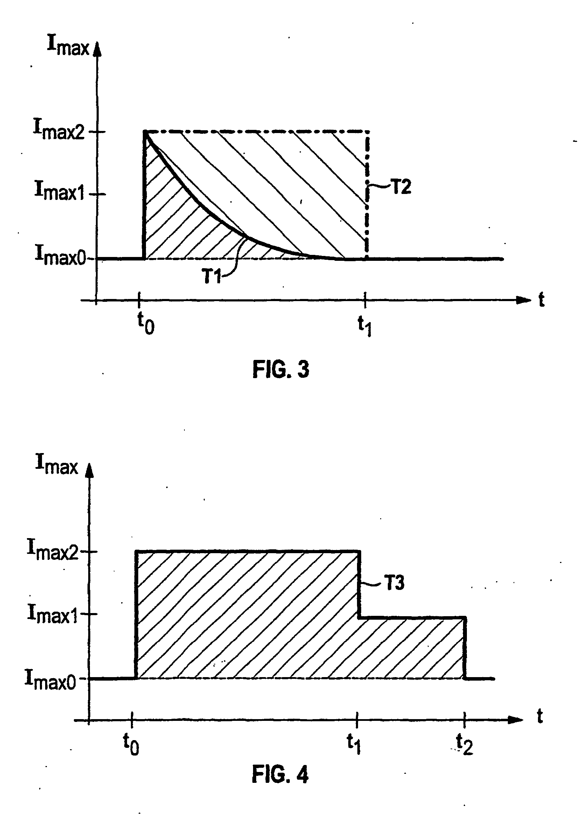

FIG 3 und FIG 4 zeigen verschiedene Ansteuerungen des Maximalstromes Iₘₐₓ des JFET-Schutzelements 3 gemäß FIG 1 und damit dessen Kennlinie gemäß FIG 2. In den Diagrammen gemäß FIG 3 und 4 ist der Maximalstrom (Sättigungsstrom) Iₘₐₓ des JFET-Schutzelements 3 als Funktion der Zeit t dargestellt. In FIG 3 ist mit einer durchgezogenen Linie ein zeitlicher Verlauf (Zeitprofil) T1 und mit einer strichpunktierten Linie ein zweiter zeitlicher Verlauf T2 für den Maximalstrom Iₘₐₓ = I-ₘₐₓ(t) gezeigt. In FIG 4 ist ein einziger zeitlicher Verlauf T3 veranschaulicht.

Vor einem Einschaltzeitpunkt t₀, zu dem das Schaltelement 2 eingeschaltet wird, ist der Maximalstrom Iₘₐₓ bei allen drei Steuerkennlinien T1, T2 und T3 auf seinem Wert Iₘₐₓ₀, die Steuerspannung U_{S} für das JFET-Schutzelement 3 also 0 V. Zu dem Einschaltzeitpunkt t₀ oder kurz danach wird der Maximalstrom Iₘₐₓ sprunghaft oder zumindest sehr schnell auf den höheren Wert Iₘₐₓ₂ erhöht, indem die Steuerspannung U_{S} für das JFET-Schutzelement 3 auf den Wert U_{S2} > 0 V erhöht wird.

Gemäß dem Zeitprofil T1 in FIG 3 fällt nun der Maximalstrom Iₘₐₓ wieder exponentiell ab, bis beim Zeitpunkt t₁ wieder der alte niedrige Wert Iₘₐₓ₀ erreicht ist. Dieser Verlauf T1 entspricht im wesentlichen einer Ansteuerung gemäß FIG 1 mit einem sich entladenden Kondensator.

Gemäß dem zeitlichen Verlauf T2 in FIG 3 wird der Maximalstrom Iₘₐₓ auf seinem erhöhten Wert Iₘₐₓ₂ gehalten und dann beim Zeitpunkt t₁ wieder sprunghaft auf den niedrigen Wert Iₘₐₓ₀ erniedrigt. Dieser Verlauf T2 ist also im wesentlichen binär.

Beim zeitlichen Verlauf T3 gemäß FIG 4 wird dagegen der der Maximalstrom Iₘₐₓ auf seinem erhöhten Wert Iₘₐₓ₂ bis zu einem Zeitpunkt t₁ gehalten, dann auf den Zwischenwert Iₘₐₓ₁ erniedrigt und erst zum Zeitpunkt t₂ wieder auf den ursprünglichen niedrigen Wert Iₘₐₓ₀ zurückgeführt.

Bei allen Ausführungsbeispielen gemäß FIG 3 und 4 wird nach dem Einschalten des Schaltelements 2 die Stromdurchlässigkeit des Schutzelements 3 erhöht und dadurch die schraffiert eingezeichnete erhöhte maximale Ladungsmenge und damit elektrische Energie durchgelassen. Durch Anpassung des Zeitintervalls t₂ - t₁ sowie der Werte Iₘₐₓ₀ bis Iₘₐₓ₂ können die beim Anlaufvorgang eines elektrischen Verbrauchers erforderlichen Ströme erlaubt werden und nach Abschluss des Anlaufvorganges wieder Überströme begrenzt werden.

Das Schutzelement 3 ist in allen Ausführungsformen aufgrund seiner genannten Eigenschaften vorzugsweise spannungsfester ausgebildet als das Schaltelement 2 und dazu vorzugsweise mit einem Halbleitermaterial mit einem hohen Bandabstand von wenigstens 2 eV oder einer hohen Durchbruchsfeldstärke von wenigstens 1.000.000 V/cm gebildet. Das bevorzugte Halbleitermaterial für das Schutzelement 3 ist, im allgemeinen einkristallines, siliciumcarbid (SiC), insbesondere eines oder mehrerer vorgegebener Polytypen wie dem β-Polytyp (3C-Polytyp) oder einem α-Polytyp, z. B. dem 4H-, 6H- oder 15R-Polytyp. Das Schutzelement 3 kann aber auch aus einem anderen Halbleitermaterial bestehen, insbesondere Silicium, und wird dann entsprechend dimensioniert. Als Schutzelement 3 kommt außer einem JFET auch ein MESFET und, eingeschränkt, auch ein MOSFET oder IGBT in Betracht.

Im allgemeinen ist das Schaltelement 2 ein Halbleiterbauelement auf Basis von Silicium (Si) ausgebildet und kann außer als MOSFET auch als MESFET, Thyristor, IGBT oder MCT ausgebildet sein.

## Patentansprüche

1. Schalteinrichtung umfassend
a) wenigstens ein Schaltelement (2) mit einem ausgeschalteten Zustand und einem eingeschalteten Zustand, sowie
b) wenigstens ein Schutzelement (3), das zum Schaltelement elektrisch in Reihe geschaltet ist und den durch die Reihenschaltung aus Schaltelement und Schutzelement fließenden elektrischen Strom auf einen Maximalstrom begrenzt,
c) wobei das wenigstens eine Schutzelement einen Steueranschluss (3C) aufweist, und
d) Steuermittel (4,5,C,R₃,31), die ein Steuersignal (P_{S}) an den Steueranschluss des Schutzelements anlegen, und mittels des Steuersignals den Maximalstrom des Schutzelements
d1) bei, oder zeitverzögert zu dem Einschalten des Schaltelements wenigstens im zeitlichen Mittel auf wenigstens einen erhöhten Wert für den Startbetrieb und
d2) anschließend wieder auf wenigstens einen niedrigeren Wert für den Dauerbetrieb
steuern.

2. Schalteinrichtung nach Anspruch 1, bei der die Steuermittel den Maximalstrom für ein vorgegebenes oder vorgebbares Zeitintervall erhöhen oder auf dem wenigstens einen erhöhten Wert halten.

3. Schalteinrichtung nach Anspruch 2, bei der das Zeitintervall, während dem die Steuermittel den wenigstens einen erhöhten Wert des Maximalstromes des Schutzelements aufrechterhalten, der beim Anlauf oder Start eines elektrischen Verbrauchers, insbesondere eines elektrischen Antriebes, benötigten Anlaufzeit oder Startzeit angepasst oder anpassbar ist.

4. Schalteinrichtung nach einem der vorhergehenden Ansprüche, bei der das Schutzelement durch die Strombegrenzung das Schaltelement im eingeschalteten Zustand vor einer zu hohen thermischen Belastung in einem Gefährdungsfall schützt, bei dem zu hohe prospektive Überströme oder Kurzschlussströme durch das Schaltelement fließen würden.

5. Schalteinrichtung nach einem der vorhergehenden Ansprüche, bei der die Steuermittel den Maximalstrom des Schutzelements zwischen genau einem niedrigeren Wert und genau einem erhöhten Wert steuern.

6. Schalteinrichtung nach Anspruch 5, bei der die Steuermittel den Maximalstrom des Schutzelements zwischen dem erhöhten Wert und dem niedrigeren Wert oder zwischen dem niedrigeren Wert und dem erhöhten Wert diskontinuierlich, insbesondere sprunghaft, steuern.

7. Schalteinrichtung nach Anspruch 5, bei der die Steuermittel den Maximalstrom des Schutzelements zwischen dem erhöhten Wert und dem niedrigeren Wert oder zwischen dem niedrigeren Wert und dem erhöhten Wert kontinuierlich steuern.

8. Schalteinrichtung nach einem der vorhergehenden Ansprüche, bei der die Steuermittel den Maximalstrom des Schutzelements gemäß einem vorgegebenen oder vorgebbaren zeitlichen Verlauf erhöhen oder erhöht halten.

9. Schalteinrichtung nach einem der vorhergehenden Ansprüche, bei der der wenigstens eine erhöhte Wert bzw. der zeitliche Verlauf des Maximalstromes des Schutzelements dem beim Anlauf oder Start eines elektrischen Verbrauchers, insbesondere eines elektrischen Antriebes, benötigten Anlaufstrom oder Startstrom bzw. dessen zeitlichem Verlauf angepasst ist.

10. Schalteinrichtung nach Anspruch 9, bei der der wenigstens eine niedrigere Wert des Maximalstromes des Schutzelements dem maximal zulässigen Überstrom des elektrischen Verbrauchers im Betrieb nach Beendigung des Anlaufes oder Startes des elektrischen Verbrauchers angepasst ist.

11. Schalteinrichtung nach einem der vorhergehenden Ansprüche, bei der der wenigstens eine erhöhte Wert des Maximalstromes des Schutzelements deutlich niedriger liegt als ein prospektiver Kurzschlussstrom.

12. Schalteinrichtung nach einem der vorhergehenden Ansprüche, bei der der wenigstens eine erhöhte Wert des Maximalstromes des Schutzelements um wenigstens einen Faktor 2, vorzugsweise um wenigstens einen Faktor 3, größer ist als der wenigstens eine niedrigere Wert.

13. Schalteinrichtung nach einem der vorhergehenden Ansprüche, bei der die Steuermittel wenigstens einen Kondensator (C) zum Erzeugen eines dem erhöhten Wert oder den erhöhten Werten des Maximalstromes des Schutzelements entsprechenden Steuersignals für das Schutzelement umfassen.

14. Schalteinrichtung nach Anspruch 13, bei der die Steuermittel wenigstens einen, vorzugsweise zu dem Kondensator parallel geschalteten, Entladewiderstand (R3) aufweisen.

15. Schalteinrichtung nach Anspruch 13 oder Anspruch 14, bei der die Steuermittel eine Hilfsenergiequelle (31) zum Aufladen des Kondensators umfassen.

16. Schalteinrichtung nach Anspruch 15, bei der die Steuermittel einen Aufladeschalter (5) umfassen, der zwischen die Hilfsenergiequelle und den Kondensator geschaltet ist.

17. Schalteinrichtung nach Anspruch 16, bei der der Aufladeschalter zusammen mit dem Schaltelement schaltbar ist, derart, dass der Aufladeschalter in seinem ausgeschalteten Zustand ist, wenn das Schaltelement in seinem eingeschalteten Zustand ist, und in seinem eingeschalteten Zustand ist, wenn das Schaltelement in seinem ausgeschalteten Zustand ist.

18. Schalteinrichtung nach einem der Ansprüche 13 bis 17, bei der die Steuermittel einen Entladeschalter (4) umfassen, der zwischen den Kondensator und den Steueranschluss des Schutzelements geschaltet ist.

19. Schalteinrichtung nach Anspruch 18 und Anspruch 14, bei der der Entladeschalter auch zwischen Kondensator und Entladewiderstand geschaltet ist.

20. Schalteinrichtung nach Anspruch 18 oder Anspruch 19, bei der der Entladeschalter zusammen mit dem Schaltelement schaltbar ist, derart, dass der Entladeschalter, gegebenenfalls mit einer vorgegebenen Zeitverzögerung, in seinem eingeschalteten Zustand ist, wenn das Schaltelement in seinem eingeschalteten Zustand ist, und in seinem ausgeschalteten Zustand ist, wenn das Schaltelement in seinem ausgeschalteten Zustand ist.

21. Schalteinrichtung nach einem der vorhergehenden Ansprüche, bei der das Schaltelement wenigstens einen Schaltanschluss (2C) aufweist und Schaltsignalerzeugungsmittel (40) vorgesehen sind zum Anlegen eines Schaltsignals an den Schaltanschluss des Schaltelements zum Ein- und Ausschalten des Schaltelements.

22. Schalteinrichtung nach Anspruch 21 einerseits und Anspruch 17 und/oder Anspruch 20 andererseits, bei der die Schaltsignalerzeugungsmittel das Schaltsignal auch an einen Schalteranschluss des Aufladeschalters und/oder des Entladeschalters anlegen.

23. Schalteinrichtung nach einem der Ansprüche 17 bis 22, bei der der Aufladeschalter wenigstens eine MISFET-Struktur, insbesondere eine MOSFET-Struktur, insbesondere vom selbstleitenden Typ, und der Entladeschalter wenigstens eine MISFET-Struktur, insbesondere eine MOSFET-Struktur, insbesondere vom selbstsperrenden Typ, umfassen.

24. Schalteinrichtung nach einem der vorhergehenden Ansprüche, bei der das Schutzelement ein Halbleiterbauelement mit wenigstens einem Halbleiter mit einer Durchbruchsfeldstärke von wenigstens 10⁶ V/cm und/oder einem Bandabstand von wenigstens 2 eV umfasst, insbesondere einen oder mehrere Halbleiter aus der Siliciumcarbid (SiC), vorzugsweise vom α- oder β-Polytyp, Galliumnitrid (GaN), Diamant, Aluminiumnitrid (AlN) und Indiumnitrid (InN) umfassenden Gruppe von Halbleitern, umfasst.

25. Schalteinrichtung nach einem der vorhergehenden Ansprüche, bei der das Schaltelement ein Halbleiterbauelement mit einem oder mehreren Halbleitern aus der Silicium (Si), Galliumarsenid (GaAs), Germanium (Ge) umfassenden Gruppe von Halbleitern umfasst.

26. Schalteinrichtung nach einem der vorhergehenden Ansprüche, bei der das Schutzelement ein Sättigungsverhalten aufweist und der Maximalstrom der Sättigungsstrom ist.

27. Schalteinrichtung nach einem der vorhergehenden Ansprüche, bei der das Schutzelement wenigstens einen p-n-Übergang und/oder wenigstens einen Schottky-Übergang aufweist.

28. Schalteinrichtung nach einem der vorhergehenden Ansprüche, bei der das Schutzelement und/oder das Schaltelement wenigstens eine JFET-Struktur umfassen bzw. umfasst.

29. Schalteinrichtung nach einem der vorhergehenden Ansprüche, bei der das Schutzelement und/oder das Schaltelement wenigstens eine MESFET-Struktur umfassen bzw. umfasst.

30. Schalteinrichtung nach einem der vorhergehenden Ansprüche, bei der das Schaltelement wenigstens eine MISFET-Struktur, insbesondere eine MOSFET-Struktur, umfasst, insbesondere vom selbstsperrenden Typ.

31. Schalteinrichtung nach Anspruch 28 oder Anspruch 29 und nach Anspruch 30, bei der der Gateanschluss der JFET-Struktur bzw. MESFET-Struktur des Schutzelementes, insbesondere über den Entladewiderstand, mit dem Sourceanschluss der MISFET-Struktur des Schaltelements verbunden ist und der Sourceanschluss der JFET-Struktur bzw. MESFET-Struktur mit dem Drainanschluss der MISFET-Struktur verbunden ist.

32. Schalteinrichtung nach einem der vorhergehenden Ansprüche, bei der der Maximalstrom des Schutzelements immer kleiner ist als ein thermischer Grenzstrom des Schaltelements, insbesondere um wenigstens einen Faktor 2, vorzugsweise um wenigstens einen Faktor 3.

33. Verfahren zum Betreiben einer Schalteinrichtung, insbesondere einer Schalteinrichtung nach einem der vorhergehenden Ansprüche, die wenigstens ein ein- und ausschaltbares Schaltelement (2) sowie wenigstens ein zum Schaltelement elektrisch in Reihe geschaltetes Schutzelement (3), das den durch die Reihenschaltung aus Schaltelement und Schutzelement fließenden elektrischen Strom auf einen Maximalstrom begrenzt und das einen Steueranschluss (3C) umfasst, an den die Steuermittel ein Steuersignal (P_{S}) anlegen, aufweist, bei dem mittels der Steuermittel und deren Steuersignal
a) zeitgleich mit oder mit einer vorgegebenen oder vorgebbaren Zeitverzögerung nach dem Einschalten des Schaltelements für den Startbetrieb der Maximalstrom des Schutzelements wenigstens im zeitlichen Mittel erhöht wird oder auf wenigstens einen erhöhten Wert gehalten wird und
b) anschließend für den Dauerbetrieb der Maximalstrom des Schutzelements wieder verringert wird.

34. Verfahren nach Anspruch 33, bei dem der Maximalstrom für ein vorgegebenes oder vorgebbares Zeitintervall erhöht wird oder auf dem wenigstens einen erhöhten Wert gehalten wird.

35. Verfahren nach Anspruch 34, bei dem das Zeitintervall, während dem der wenigstens eine erhöhte Wert des Maximalstromes des Schutzelements aufrechterhalten wird, der beim Anlauf oder Start eines elektrischen Verbrauchers, insbesondere eines elektrischen Antriebes, benötigten Anlaufzeit oder Startzeit angepasst ist oder angepasst wird.

36. Verfahren nach einem der Ansprüche 33 bis 35, bei dem der Maximalstrom des Schutzelements zwischen genau einem niedrigeren Wert und genau einem erhöhten Wert und/oder zwischen dem niedrigeren Wert und dem erhöhten Wert, insbesondere unstetig oder stetig, gesteuert wird.

37. Verfahren nach Anspruch 36, bei dem der Maximalstrom von dem erhöhten Wert im wesentlichen monoton fallend auf den niedrigeren Wert reduziert wird.

38. Verfahren nach einem der Ansprüche 33 bis 37, bei dem der Maximalstrom des Schutzelements gemäß einem vorgegebenen oder vorgebbaren zeitlichen Verlauf erhöht oder auf einem erhöhten Wert gehalten wird.

39. Verfahren nach einem der Ansprüche 33 bis 38, bei dem der wenigstens eine erhöhte Wert bzw. der zeitliche Verlauf des Maximalstromes des Schutzelements dem beim Anlauf oder Start eines elektrischen Verbrauchers, insbesondere eines elektrischen Antriebes, benötigten Anlaufstrom oder Startstrom angepasst ist oder wird.

40. Verfahren nach Anspruch 39, bei dem der wenigstens eine niedrigere Wert des Maximalstromes des Schutzelements dem maximal zulässigen Überstrom des elektrischen Verbrauchers im Betrieb nach Beendigung des Anlaufes oder Starts des elektrischen Verbrauchers angepasst ist.

41. Verfahren nach einem der Ansprüche 33 bis 40, bei dem der wenigstens eine erhöhte Wert des Maximalstromes des Schutzelements deutlich niedriger, vorzugsweise um wenigstens einen Faktor 3 niedriger, eingestellt wird als ein prospektiver Kurzschlussstrom.

42. Verfahren nach einem der vorhergehenden Ansprüche, bei dem der wenigstens eine erhöhte Wert des Maximalstromes des Schutzelements um wenigstens einen Faktor 2, vorzugsweise um wenigstens einen Faktor 3, größer eingestellt wird als der wenigstens eine niedrigere Wert.

## Claims

1. A switching device comprising
a) at least one switching element (2) having a switched-off state and a switched-on state, and also
b) at least one protection element (3), which is electrically connected in series with the switching element and limits the electric current flowing through the series circuit of switching element and protection element to a maximum current,
c) with the at least one protective element featuring a control connection (3C), and
d) control means (4, 5, C, R₃, 31) which apply a control signal (P₃), and which control the maximum current of the protection element
d1) in the event of, or in a time-delayed manner with respect to, the switch-on of the switching element at least on average with respect to time to at least one increased value for start-up operation and
d2) subsequently to at least one lower value again for continuous operation.

2. Switching device in accordance with Claim 1, in which the control means increase the maximum current, or hold it at the at least one increased value, for a predetermined or predeterminable time interval.

3. Switching device in accordance with Claim 2, in which the time interval during which the control means maintain the at least one increased value of the maximum current of the protection element is adapted or adaptable to the start-up time or start time required in the event of the start-up or start of an electrical load, in particular of an electrical drive.

4. Switching device in accordance with one of the preceding claims, in which the protection element protects the switching element from a thermal load which is too high in a danger situation in which prospective overcurrents which are too high or short circuit currents would flow through the switching element by limiting the current in the switched-on state

5. Switching device in accordance with one of the preceding claims, in which the control means control the maximum current of the protection element between precisely one lower value and precisely one increased value.

6. Switching device in accordance with Claim 5, in which the control means control the maximum current of the protection element between the increased value and the lower value or between the lower value and the increased value discontinuously, in particular by abrupt change.

7. Switching device in accordance with Claim 5, in which the control means control the maximum current of the protection element between the increased value and the lower value or between the lower value and the increased value continuously.

8. Switching device in accordance with one of the preceding claims, in which the control means increase the maximum current of the protection element, or keep it increased, in accordance with a predetermined or predeterminable temporal profile.

9. Switching device in accordance with one of the preceding claims, in which the at least one increased value or the temporal profile of the maximum current of the protection element is adapted to the start-up current or start current, or the temporal profile thereof, required in the event of the start-up or start of an electrical load, in particular of an electrical drive.

10. Switching device in accordance with Claim 9, in which the at least one lower value of the maximum current of the protection element is adapted to the maximum permissible overcurrent of the electrical load in operation after the end of the start-up or start of the electrical load.

11. Switching device in accordance with one of the preceding claims, in which the at least one increased value of the maximum current of the protection element is significantly lower than a prospective short-circuit current.

12. Switching device in accordance with one of the preceding claims, in which the at least one increased value of the maximum current of the protection element is greater than the at least one lower value by at least a factor of 2, preferably by at least a factor of 3.

13. Switching device in accordance with Claim 12, in which the control means comprise at least one capacitor (C) for generating a control signal for the protection element, which corresponds to the increased value or the increased values of the maximum current of the protection element.

14. Switching device in accordance with Claim 13, in which the control means have at least one discharge resistor (R3) preferably connected in parallel with the capacitor.

15. Switching device in accordance with Claim 13 or Claim 14, in which the control means comprise an auxiliary energy source (31) for charging the capacitor.

16. Switching device in accordance with Claim 15, in which the control means comprise a charging switch (5), which is connected between the auxiliary energy source and the capacitor.

17. Switching device in accordance with Claim 16, in which the charging switch can be switched together with the switching element in such a way that the charging switch is in its switched-off state if the switching element is in its switched-on state, and is in its switched-on state if the switching element is in its switched-off state.

18. Switching device in accordance with one of Claims 13 to 17, in which the control means comprise a discharge switch (4), which is connected between the capacitor and the control terminal of the protection element.

19. Switching device in accordance with Claim 18 and Claim 14, in which the discharge switch is also connected between capacitor and discharge resistor.

20. Switching device in accordance with Claim 18 or claim 19, in which the discharge switch can be switched together with the switching element in such a way that the discharge switch, if appropriate with a predetermined time delay, is in its switched-on state if the switching element is in its switched-on state, and is in its switched-off state if the switching element is in its switched-off state.

21. Switching device in accordance with one of the preceding claims, in which the switching element has at least one switching terminal (2C) and switching signal generating means (40) are provided for applying a switching signal to the switching terminal of the switching element for switching the switching element on and off.

22. Switching device in accordance with Claim 21, on the one hand, and Claim 17 and/or Claim 20 on the other hand, in which the switching signal generating means apply the switching signal also to a switch terminal of the charging switch and/or of the discharge switch.

23. Switching device in accordance with one of claims 17 to 22, in which the charging switch comprises at least one MISFET structure, in particular a MOSFET structure, in particular of the normally on type, and the discharge switch comprises at least one MISFET structure, in particular a MOSFET structure, in particular of the normally off type.

24. Switching device in accordance with one of the preceding claims, in which the protection element comprises a semiconductor component having at least one semiconductor having a breakdown field strength of at least 10⁶ V/cm and/or a band gap of at least 2 eV, in particular comprises one or more semiconductors from the group of semiconductors comprising silicon carbide (SiC), preferably of the a or β polytype, gallium nitride (GaN), diamond, aluminium nitride (A1N) and indium nitride (InN).

25. Switching device in accordance with one of the preceding claims, in which the switching element comprises a semiconductor component having one or more semiconductors from the group of semiconductors comprising silicon (Si), gallium arsenide (GaAs), germanium (Ge).

26. Switching device in accordance with one of the preceding claims, in which the protection element has a saturation behaviour and the maximum current is the saturation current.

27. Switching device in accordance with one of the preceding claims, in which the protection element has at least one p-n junction and/or at least one Schottky junction.

28. Switching device in accordance with one of the preceding claims, in which the protection element and/or the switching element comprise or comprises at least one JFET structure.

29. Switching device in accordance with one of the preceding claims, in which the protection element and/or the switching element comprise or comprises at least one MESFET structure.

30. Switching device in accordance with one of the preceding claims,
in which the switching element comprises at least one MISFET structure, in particular a MOSFET structure, in particular of the normally off type.

31. Switching device in accordance with Claim 28 or Claim 29, and in accordance with Claim 30, in which the gate terminal of the JFET structure or MESFET structure of the protection element is connected, in particular via the discharge resistor, to the source terminal of the MISFET structure of the switching element and the source terminal of the JFET structure or MESFET structure is connected to the drain terminal of the MISFET structure.

32. Switching device in accordance with one of the preceding claims, in which the maximum current of the protection element is always less than a thermal limiting current of the;switching element, in particular by at least a factor of 2, preferably by at least a factor of 3.

33. A method for operating a switching device, in particular a switching device in accordance with one of the preceding claims, which has at least one switching element (2) that can be switched on and off and also at least one protection element (3), which is electrically connected in series with the switching element and limits the current to a maximum current, and which includes a control connection (3C) to which the control means apply a control signal (P₃),
in which, by means of the control means and its control signal
a) at the same time as or with a predetermined or predeterminable time delay after switch-on of the switching element, the maximum current of the protection element, at least on average with respect to time, is increased or is held at at least one increased value for start-up operation, and
b) the maximum current of the protection element is subsequently reduced again for continuous operation.

34. Method in accordance with Claim 33, in which the maximum current is increased, or is held at the at least one increased value, for a predetermined or predeterminable time interval.

35. Method in accordance with Claim 34, in which the time interval during which the at least one increased value of the maximum current of the protection element is maintained has been adapted or is adapted to the start-up time or start time required in the event of the start-up or start of an electrical load, in particular of an electrical drive.

36. Method in accordance with Claims 33 to 35, in which the maximum current of the protection element is controlled between precisely one lower value and precisely one increased value and/or between the lower value and the increased value, in particular discontinuously or continuously.

37. Method in accordance with Claim 36, in which the maximum current is reduced from the increased value in a manner essentially falling monotonically to the lower value.

38. Method in accordance with one of Claims 33 to 37, in which the maximum current of the protection element is increased or kept increased in accordance with a predetermined or predeterminable temporal profile.

39. Method in accordance with one of Claims 33 to 38, in which the at least one increased value or the temporal profile of the maximum current of the protection element has been or is adapted to the start-up current or start current required in the event of the start-up or start of an electrical load, in particular of an electrical drive.

40. Method in accordance with Claim 39, in which the at least one lower value of the maximum current of the protection element is adapted to the maximum permissible overcurrent of the electrical load in operation after the end of the start-up or start of the electrical load.

41. Method in accordance with one of Claims 33 to 40, in which the at least one increased value of the maximum current of the protection element is set such that it is significantly lower, preferably lower by at least a factor of 3, than a prospective short-circuit current.

42. Method in accordance with one of the preceding claims, in which the at least one increased value of the maximum current of the protection element is set such that it is greater by at least a factor of 2, preferably by at least a factor of 3, than the at least one lower value.

## Revendications

1. Dispositif commutateur comprenant
a) au moins un élément de commutation (2) ayant un état déconnecté et un état connecté,
b) au moins un élément de protection (3) qui est branché électriquement en série avec l'élément de commutation et qui limite le courant électrique passant par le circuit série composé de l'élément de commutation et de l'élément de protection à un courant maximal,
c) le au moins un élément de protection comportant une borne de commande (3C), et
d) des moyens de commande (4, 5, C, R₃, 31 ) qui appliquent un signal de commande (P_{S}) à la borne de commande de l'élément de protection et qui commandent au moyen du signal de commande le courant maximal de l'élément de protection,
d1) lors de la connexion de l'élément de commutation ou avec un certain retard après celle-ci, au moins en moyenne temporelle à au moins une valeur supérieure pour le démarrage
d2) puis à nouveau à au moins une valeur inférieure pour le régime permanent.

2. Dispositif commutateur selon la revendication 1, dans lequel, pour un intervalle de temps prédéterminé ou pouvant être prédéterminé, les moyens de commande augmentent le courant maximal ou le maintiennent à la au moins une valeur supérieure.

3. Dispositif commutateur selon la revendication 2, dans lequel l'intervalle de temps pendant lequel les moyens de commande maintiennent la au moins une valeur supérieure du courant maximal de l'élément de protection est adapté ou peut être adapté au temps de démarrage nécessaire lors du démarrage d'un consommateur électrique, notamment d'un moteur électrique.

4. Dispositif commutateur selon l'une des revendications précédentes, dans lequel l'élément de protection protège par la limitation de courant l'élément de commutation dans l'état connecté contre une trop grande charge thermique dans un cas à risque lors duquel des surintensités de courant ou des courants de court-circuit prévisibles trop grands pourraient passer par l'élément de commutation.

5. Dispositif commutateur selon l'une des revendications précédentes, dans lequel les moyens de commande commandent le courant maximal de l'élément de protection entre exactement une valeur inférieure et exactement une valeur supérieure.

6. Dispositif commutateur selon la revendication 5, dans lequel les moyens de commande commandent le courant maximal de l'élément de protection entre la valeur supérieure et la valeur inférieure ou entre la valeur inférieure et la valeur supérieure de façon discontinue, notamment brusque.

7. Dispositif commutateur selon la revendication 5, dans lequel les moyens de commande commandent le courant maximal de l'élément de protection entre la valeur supérieure et la valeur inférieure ou entre la valeur inférieure et la valeur supérieure de façon continue.

8. Dispositif commutateur selon l'une des revendications précédentes, dans lequel les moyens de commande augmentent ou maintiennent augmenté le courant maximal de l'élément de protection selon une allure temporelle prédéterminée ou pouvant être prédéterminée.

9. Dispositif commutateur selon l'une des revendications précédentes, dans lequel la au moins une valeur supérieure ou l'allure temporelle du courant maximal de l'élément de protection est adaptée au courant de démarrage nécessaire lors du démarrage d'un consommateur électrique, notamment d'un moteur électrique, ou à son allure temporelle.

10. Dispositif commutateur selon la revendication 9, dans lequel la au moins une valeur inférieure du courant maximal de l'élément de protection est adaptée à la surintensité de courant maximale autorisée du consommateur électrique lors du fonctionnement après la fin du démarrage du consommateur électrique.

11. Dispositif commutateur selon l'une des revendications précédentes, dans lequel la au moins une valeur supérieure du courant maximal de l'élément de protection est nettement inférieure à un courant de court-circuit prévisible.

12. Dispositif commutateur selon l'une des revendications précédentes, dans lequel la au moins une valeur supérieure du courant maximal de l'élément de protection est supérieure d'au moins un facteur 2, de préférence d'au moins un facteur 3, à la au moins une valeur inférieure.

13. Dispositif commutateur selon l'une des revendications précédentes, dans lequel les moyens de commande comprennent au moins un condensateur (C) pour produire un signal de commande destiné à l'élément de protection et correspondant à la valeur supérieure ou aux valeurs supérieures du courant maximal de l'élément de protection.

14. Dispositif commutateur selon la revendication 13, dans lequel les moyens de commande comportent au moins une résistance de décharge (R₃) branchée de préférence en parallèle avec le condensateur.

15. Dispositif commutateur selon la revendication 13 ou la revendication 14, dans lequel les moyens de commande comprennent une source d'énergie auxiliaire (31) pour charger le condensateur.

16. Dispositif commutateur selon la revendication 15, dans lequel les moyens de commande comprennent un interrupteur de charge (5) qui est branché entre la source d'énergie auxiliaire et le condensateur.

17. Dispositif commutateur selon la revendication 16, dans lequel l'interrupteur de charge est commutable conjointement avec l'élément de commutation de telle sorte que l'interrupteur de charge est dans son état déconnecté lorsque l'élément de commutation est dans son état connecté et l'interrupteur de charge est dans son état connecté lorsque l'élément de commutation est dans son état déconnecté.

18. Dispositif commutateur selon l'une des revendications 13 à 17, dans lequel les moyens de commande comprennent un interrupteur de décharge (4) qui est branché entre le condensateur et la borne de commande de l'élément de protection.

19. Dispositif commutateur selon la revendication 18 et la revendication 14, dans lequel l'interrupteur de décharge est aussi branché entre le condensateur et la résistance de décharge.

20. Dispositif commutateur selon la revendication 18 ou la revendication 19, dans lequel l'interrupteur de décharge est commutable conjointement avec l'élément de commutation de telle sorte que l'interrupteur de décharge, éventuellement avec un retard prédéterminé, est dans son état connecté lorsque l'élément de commutation est dans son état connecté et est dans son état déconnecté lorsque l'élément de commutation est dans son état déconnecté.

21. Dispositif commutateur selon l'une des revendications précédentes, dans lequel l'élément de commutation comporte au moins une borne de commutation (2C) et dans lequel des moyens de production de signal de commutation (40) sont prévus pour appliquer un signal de commutation à la borne de commutation de l'élément de commutation pour la connexion et la déconnexion de l'élément de commutation.

22. Dispositif commutateur selon la revendication 21 d'une part et la revendication 17 et/ou la revendication 20 d'autre part, dans lequel les moyens de production de signal de commutation appliquent aussi le signal de commutation à une borne d'interrupteur de l'interrupteur de charge et/ou de l'interrupteur de décharge.

23. Dispositif commutateur selon l'une des revendications 17 à 22, dans lequel l'interrupteur de décharge comprend au moins une structure MISFET, notamment une structure MOSFET, notamment du type autoconducteur, et l'interrupteur de décharge comprend au moins une structure MISFET, notamment une structure MOSFET, notamment du type autobloquant.

24. Dispositif commutateur selon l'une des revendications précédentes, dans lequel l'élément de protection comprend un composant à semi-conducteur avec au moins un semi-conducteur ayant une intensité de champ de claquage d'au moins 10⁶ V/cm et/ou un intervalle de bande d'au moins 2 eV, notamment un ou plusieurs semi-conducteurs du groupe de semi-conducteurs comprenant le carbure de silicium (SiC), de préférence du polytype α ou β, le nitrure de gallium (GaN), le diamant, le nitrure d'aluminium (AIN) et le nitrure d'indium (InN).

25. Dispositif commutateur selon l'une des revendications précédentes, dans lequel l'élément de commutation comprend un composant à semi-conducteur avec un ou plusieurs semi-conducteurs du groupe comprenant le silicium (Si), l'arséniure de gallium (GaAs), le germanium (Ge).

26. Dispositif commutateur selon l'une des revendications précédentes, dans lequel l'élément de protection a un comportement de saturation et le courant maximal est le courant de saturation.

27. Dispositif commutateur selon l'une des revendications précédentes, dans lequel l'élément de protection comporte au moins une jonction p-n et/ou au moins une jonction de Schottky.

28. Dispositif commutateur selon l'une des revendications précédentes, dans lequel l'élément de protection et/ou l'élément de commutation comprennent au moins une structure JFET.

29. Dispositif commutateur selon l'une des revendications précédentes, dans lequel l'élément de protection et/ou l'élément de commutation comprennent au moins une structure MESFET.

30. Dispositif commutateur selon l'une des revendications précédentes, dans lequel l'élément de commutation comprend au moins une structure MISFET, notamment une structure MOSFET, notamment du type autobloquant.

31. Dispositif commutateur selon la revendication 28 ou la revendication 29 et selon la revendication 30, dans lequel la borne de grille de la structure JFET ou de la structure MESFET de l'élément de protection est reliée, notamment par l'intermédiaire de la résistance de décharge, à la borne de source de la structure MISFET de l'élément de commutation et la borne de source de la structure JFET ou de la structure MESFET est reliée à la borne de drain de la structure MISFET.

32. Dispositif commutateur selon l'une des revendications précédentes, dans lequel le courant maximal de l'élément de protection est toujours plus petit qu'un courant limite thermique de l'élément de commutation, notamment d'au moins un facteur 2, de préférence d'au moins un facteur 3.

33. Procédé pour faire fonctionner un dispositif commutateur, notamment un dispositif commutateur selon l'une des revendications précédentes, qui comporte au moins un élément de commutation (2) qui peut être connecté et déconnecté ainsi qu'au moins un élément de protection (3) qui est branché électriquement en série avec l'élément de commutation, qui limite le courant électrique passant par le circuit série composé de l'élément de commutation et de l'élément de protection à un courant maximal et qui comprend une borne de commande (3C) à laquelle les moyens de commande appliquent un signal de commande (P_{S}),
dans I equel, à l'aide des moyens de commande et de leur signal de commande,
a) en même temps que la connexion de l'élément de commutation ou avec un retard prédéterminé ou pouvant être prédéterminé après la connexion de l'élément de commutation, on augmente pour le démarrage le courant maximal de l'élément de protection au moins en moyenne temporelle ou on le maintient à au moins une valeur supérieure
b) puis on réduit à nouveau le courant maximal de l'élément de protection pour le régime permanent.

34. Procédé selon la revendication 33, dans lequel, pour un intervalle de temps prédéterminé ou pouvant être prédéterminé, on augmente le courant maximal ou on le maintient à la au moins une valeur supérieure.

35. Procédé selon la revendication 34, dans lequel on a adapté ou on adapte l'intervalle de temps, pendant lequel la au moins une valeur supérieure du courant maximal de l'élément de protection est maintenue, au temps de démarrage nécessaire lors du démarrage d'un consommateur électrique, notamment d'un moteur électrique. ,

36. Procédé selon l'une des revendications 33 à 35, dans lequel on commande le courant maximal de l'élément de protection entre exactement une valeur inférieure et exactement une valeur supérieure et/ou entre la valeur inférieure et la valeur supérieure, notamment de manière discontinue ou continue.

37. Procédé selon la revendication 36, dans lequel on réduit le courant maximal de la valeur supérieure à la valeur inférieure suivant une décroissance globalement monotone.

38. Procédé selon l'une des revendications 33 à 37, dans lequel on augmente le courant maximal de l'élément de protection selon une allure temporelle prédéterminée ou pouvant être prédéterminée ou on le maintient à une valeur supérieure.

39. Procédé selon l'une des revendications 33 à 38, dans lequel on a adapté ou on adapte la au moins une valeur supérieure ou l'allure temporelle du courant maximal de l'élément de protection au courant de démarrage nécessaire lors du démarrage d'un consommateur électrique, notamment d'un moteur électrique.

40. Procédé selon la revendication 39, dans lequel on a adapté la au moins une valeur inférieure du courant maximal de l'élément de protection à la surintensité de courant maximale autorisée du consommateur électrique lors du fonctionnement après la fin du démarrage du consommateur électrique.

41. Procédé selon l'une des revendications 33 à 40, dans lequel on règle la au moins une valeur supérieure du courant maximal de l'élément de protection très inférieure, de préférence inférieure d'au moins un facteur 3, à un courant de court-circuit prévisible.

42. Procédé selon l'une des revendications précédentes, dans lequel on règle la au moins une valeur supérieure du courant maximal de l'élément de protection supérieure d'au moins un facteur 2, de préférence d'au moins un facteur 3, à la au moins une valeur inférieure.
